# EUROPÄISCHE PATENTSCHRIFT

(11) **EP 1 825 512 B1**
(45) Veröffentlichungstag und Bekanntmachung des Hinweises auf die Patenterteilung: **07.04.2010**
(21) Anmeldenummer: 05815884.1
(22) Anmeldetag: 05.12.2005
(51) Int. Cl.: H01L 27/32

(54) **ELEKTRONISCHES BAUELEMENT MIT PIXELN AUF ORGANISCHER BASIS**
ORGANIC-BASED ELECTRONIC COMPONENT CONTAINING PIXELS
COMPOSANT ELECTRONIQUE COMPRENANT DES PIXELS A BASE ORGANIQUE

(30) Priorität: 16.12.2004 DE 102004061128
(43) Veröffentlichungstag der Anmeldung: 29.08.2007
(73) Patentinhaber: SIEMENS AKTIENGESELLSCHAFT, 80333 München (DE)
(72) Erfinder: FÜRST, Jens, 91093 Hessdorf (DE); HENSELER, Debora, 91052 Erlangen (DE); KLAUSMANN, Hagen, 82110 Germering (DE)
(86) Internationale Anmeldenummer: PCT/EP2005/056482
(87) Internationale Veröffentlichungsnummer: WO 2006/063952

(56) Entgegenhaltungen:
- US-A1- 2004 085 598
- US-A1- 2004 178 719
- US-B1- 6 326 230

## Beschreibung

Die Erfindung betrifft ein elektronisches Bauelement auf organischer Basis, insbesondere eines mit reduziertem Pixel-Crosstalk oder Übersprechen.

Elektronische Bauelemente auf organischer Basis sind beispielsweise in Form von Photodioden mit organischen halbleitenden, leitenden und/oder isolierenden Materialien bekannt und umfassen in der Regel zumindest eine Schicht aus organischem halbleitendem oder leitendem Material, die in einzelne Detektorpixel unterteilt ist und die zwischen zwei Elektroden eingebettet ist. Während des Betriebs werden durch Licht in der aktiven organischen Schicht Ladungsträgerpaare erzeugt, die dann getrennt, durch die aktive Schicht hindurch transportiert und an die beiden gegenüberliegenden Elektroden abgegeben werden. Dabei finden sich freie Ladungsträger oder Ladungen in der Schicht und je nach Beweglichkeit dieser Ladungsträger innerhalb der Schicht und je nach den anliegenden Potentialverhältnissen werden diese Ladungen nicht nur zielgerichtet an die nächstliegende Pixelelektrodetransportiert, sondern auch quer zu dieser Richtung und entlang der Schicht. Damit werden aber Pixel aktiviert, die nicht aktiviert sein sollten und ein Übersprechen oder ein Crosstalk des Signals entsteht.

Die einzelnen Pixel sollten in idealer Weise einzeln anzusteuern sein oder einzeln aktiviert werden können, damit kein Verschmieren eines Signals entsteht. Bei großflächig und kostengünstig hergestellten Schichten ist das ein Problem, weil ein Ladungstransfer in benachbarte Zonen, an denen keine Spannung anliegt, einfach nicht vermieden werden kann.

Wirtschaftlich gesehen sind diese elektronischen Bauelemente und beispielsweise die Photodioden auch in Form von pixelierten Flachdetektoren interessant, wo sie im sichtbaren Bereich mit hohen Quanteneffizienzen (50 bis 85%) des Spektrums hergestellt werden können. Die hierbei eingesetzten dünnen organischen Schichtsysteme können mit bekannten Herstellungsverfahren wie Spin-Coating, Rakeln und/oder Druckverfahren kostengünstig aufgebracht werden und entsprechend von wirtschaftlichem Interesse, vor allem für Photodioden oder sonstige pixelierte organische elektronische Bauelemente mit größeren Flächen. Kostengünstig können diese Schichten auch deshalb aufgebracht werden, weil sie unstrukturiert bleiben. So hergestellte Photodetektoren werden beispielsweise in der medizinischen Bilderkennung als Röntgen-Flachdetektoren eingesetzt, da hier das Licht einer Szintillatorschicht typischerweise auf relativ großen Flächen von mindestens einigen Zentimetern detektiert wird.

Aus der US 2004/0085598 A1 ist eine Kamera mit einem organischen Bilddetektor bekannt, wobei eine Belastungskontrolle für den Bilddetektor vorhanden ist, die zwischen Fokussierung und Öffnungs-Modus unterscheidet.

Aus der US 6326230 B1 ist ein pixelierter Bilddetektor bekannt, der einen Hochgeschwindigkeits-CMOS-Bildanzeiger mit einer Bewegungsunterdrückung hat.

Aus der US 7079093 B2 ist ein Display aus einer aktiv Matrix OLED bekannt.

Nachteilig an den bekannten Systemen ist der so genannte Crosstalk (das Übersprechen), weil bei Detektor-Arrays mit großflächigen, unstrukturierten organischen Halbleiterschichten durch die Querleitfähigkeit innerhalb dieser Schicht ein Übersprechen der generierten Ladungen vom Ort der Ladungserzeugung auf benachbarte Pixel möglich ist. Typische Leitfähigkeiten der aktiven organischen Schichten liegen im Bereich von 10⁻⁴ bis 10⁻⁶ S/cm. Simulationsergebnisse zeigen, dass hiermit bei Schichtdicken im Bereich von einigen hundert Nanometern ein starkes Abfließen von Ladungen in benachbarte Pixel erfolgen kann. Das Resultat ist eine Verschlechterung der räumlichen Auflösung, d.h. ein Verschmieren des detektierten Bildes über mehrere Pixel hinweg.

Aufgabe der Erfindung ist es daher, das Übersprechen zwischen Pixel bei vollflächigen leitfähigen organischen Schichten zu vermindern.

Diese Aufgabe wird durch den Gegenstand der Ansprüche, der Beschreibung zusammen mit den Figuren gelöst.

Gegenstand der Erfindung ist ein elektronisches Bauelement mit zumindest einer aktiven organischen halbleitenden oder leitenden Schicht, die zwischen zwei Elektroden eingebettet ist, **dadurch gekennzeichnet, dass** innerhalb des Schichtsystems und seitlich neben den pixelierten Elektroden eine Elektrode in Form eines Gitters über den gesamten aktiven Bereich gelegt ist, wobei diese Gitterelektrode mit einer Passivierungsschicht überzogen ist, einzelne oder mehrere Pixel umgrenzt und mit einer Spannung betrieben wird, die einem Ladungstransfer entlang der Schicht, also einem Übersprechen der einzelnen Pixel, entgegenwirkt.

Als elektronisches Bauelement aus vorwiegend organischem Material mit zumindest einer halbleitenden oder leitenden Schicht wird beispielsweise ein organischer Photodetektor, ein elektrochromes Bauelement, eine organische Leuchtdiode, und/oder alle Arten von Displays oder "flat paneels" bezeichnet. Die erfindungsgemäße Lösung der gestellten Aufgabe findet außerdem Anwendung beispielsweise in einer Aktiv Matrix wie einem aktiv Matrix Display und/oder bei einer Passiv Matrix wie in einem passiv Matrix Display oder in ähnlichen Geräten.

Eine Aktiv-Matrix wie in den Figuren gezeigt dabei gehört zu jedem Pixel ein Transistor, mit dem jedes Pixel einzeln auslesbar ist. Die mit dem Transistor verbundene Elektrode ist dabei in beiden Richtungen (z.B. rechteckig) auf die Pixeldimension strukturiert, die andere Elektrode ist flächig durchgehend. (Die strukturierte Elektrode kann hierbei durchaus auch die obere (Top-)Elektrode sein, wenn der Transistor über der Photodiode/Leuchtdiode oder sonstigen aktiven Schicht aufgebracht wird.)

Im Gegensatz dazu wird als Passiv-Matrix folgender Bauelement-Aufbau bezeichnet: Die Pixel werden nicht einzeln geschaltet, sondern in einem Multiplex-Verfahren getrieben (Display) oder ausgelesen (Detektor). Hierzu sind beide Elektroden streifenartig, senkrecht zueinander strukturiert. Der Nachteil dieses Aufbaus besteht im Wesentlichen darin, dass bei diesem Display kein stehendes Bild entsteht, sondern immer nur ein kurzes Aufleuchten der Pixel auf der jeweils aktiven Zeile bzw. beim Detektor. Damit wird das Licht nicht über die ganze Zeit zwischen zwei Zyklen integriert, sondern nur über den Zeitraum, in dem eine Zeile aktiv ist.

Die Gitterelektrode kann beispielsweise durch folgende Methoden aufgebracht werden: Aufdampfen, Sputtern und/oder auch bekannte Druckverfahren zum Auftragen von leitfähigen Materialien, beispielsweise wie beim hot metal printing.

Strukturierungsverfahren für die Gitterelektrodenschicht sind: Lithographische Strukturierung (bevorzugt wegen der hohen Auflösung), aufdampfen und/oder sputtern durch Masken oder Strukturierung durch Druckverfahren (weniger aufwendig).

Der Querschnitt der Gitterelektrode kann sowohl im Wesentlichen rund oder ellipsoid sein, als auch im Wesentlichen eckig mit einer Kantenlänge.

Die Periodizität des Gitters liegt beispielsweise im Bereich von 50-500 µm.

Die beiden Elektroden werden je nach Bauteil in Top- und Bottom-Elektrode eingeteilt. "Pixeliert" heißt, dass zumindest eine der aktiven Schichten des Bauelements in Pixel unterteilt ist und ist hier die Bezeichnung für die Strukturierung einer Schicht, so dass zumindest eine aktive Schicht aufgeteilt ist in erste Bereiche oder Pixel, die einzeln oder gemeinsam aktiviert werden können und dass diese ersten Bereiche oder Pixel von zweiten Bereichen umgrenzt sind, die nicht aktiviert werden können und den Grenzbereich zwischen den Pixel bilden.
Als Top-Elektrode können verschiedene Materialien dienen, beispielsweise im Fall einer Photodiode Metalle wie Ba, Ca, Mg, A1, Ag sowie Kombinationen oder Legierungen dieser Metalle, Salze wie LiF oder CsF oder Indium-Zinn-Oxid (ITO).

Als Bottom-Elektrode können verschiedene Materialien dienen, beispielsweise im Fall einer Photodiode Indium-Zinn-Oxid oder Metalle wie Silber, Chrom, Palladium, Platin, Gold, Samarium oder Kombinationen bzw. Legierungen solcher Materialien.

Die betroffenen leitfähigen oder halbleitenden Schichten aus vorwiegend organischem Material können beispielsweise folgende Materialien umfassen: Fullerene, Fullerenderivate, Polyphenylenvinylene, Polythiophene, Polyfluorene sowie Mischungen (Blends) dieser Materialsysteme und Derivate oder Copolymere dieser Materialklassen.

Die Gitterelektrode kann ein Gitter haben mit der Auflösung der Pixel, es kann aber auch großmaschiger sein oder kann verschiedene Maschengrößen an verschiedenen Stellen der Schicht haben.

Der isolierende Überzug des Gitters kann aus dem gleichen Material wie die Verkapselung des Bauteils oder die Isolatorschicht sein und dient dazu, dass keine Ladungsträger an der Gitterelektrode verloren gehen und damit die Intensität des Signals abnimmt, sondern dass lediglich zwischen den Pixeln durch die passivierte Gitterelektrode eine elektrisch geladene Zone entsteht, die das Übersprechen oder den Ladungstransfer zwischen den Pixeln unterbindet. Sie kann beispielsweise aus isolierenden, strukturierbaren Photolacken oder aus Siliziumnitrid aufgebaut sein.

Im Folgenden wird die Erfindung noch anhand von vier Figuren, die bevorzugte Ausführungsformen der Erfindung betreffen, näher erläutert:

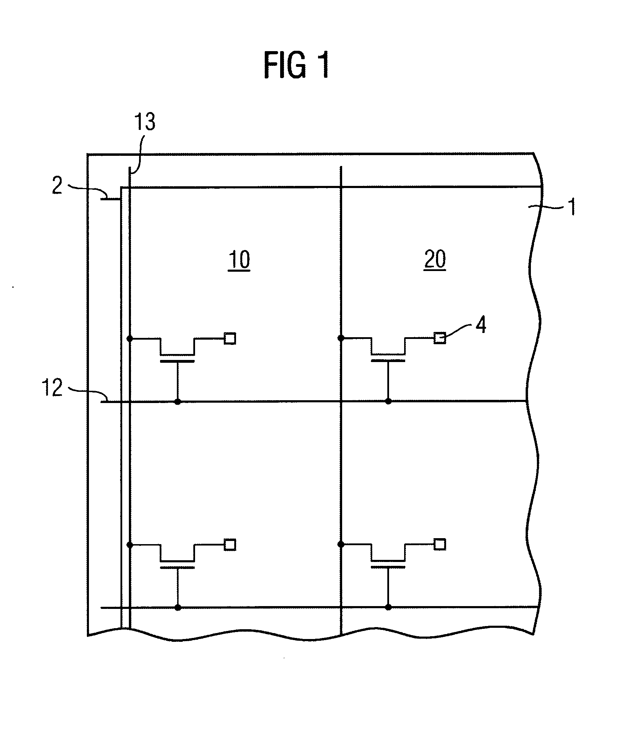

Figur 1 zeigt eine Draufsicht auf eine Bottom-Elektrodenschicht nach dem Stand der Technik:

Zu erkennen ist der prinzipielle Aufbau eines pixelierten Detektorpanels mit Aktiv-Matrix-Ansteuerung, ähnlich dem Stand der Technik für Detektoren mit anorganischen Photodioden. Das Auslesen der Ladungszustände der einzelnen Pixel erfolgt zeilenweise, indem jeweils über die Gate-Leitungen 12 alle Dünnfilmtransistoren einer Zeile angeschaltet werden. Das Auslesen selbst erfolgt dann über die Source-Leitungen 13 der Transistoren, so dass für jeden Pixel der gerade adressierten Zeile ein Signal generiert wird. Das Signal ist proportional zu der integrierten Lichtintensität seit dem letzten Auslese- oder Resetzyklus.

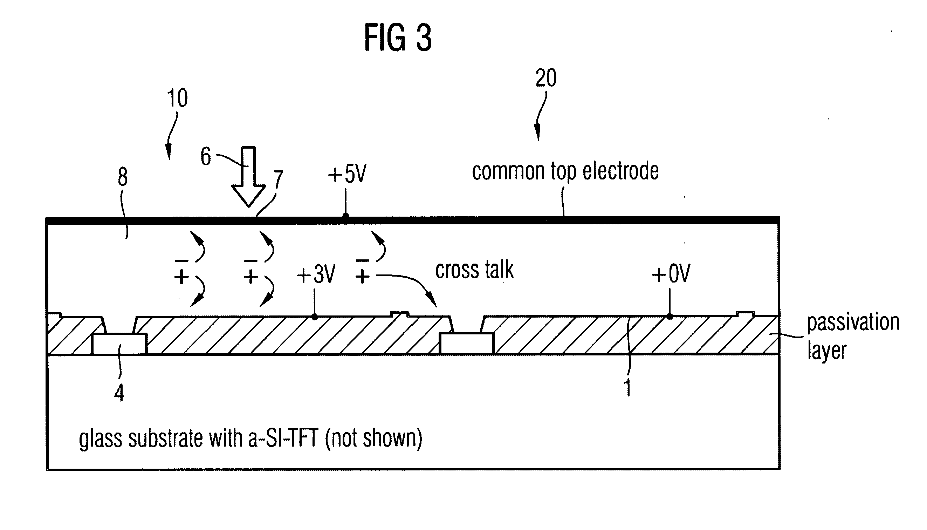

Für Detektor-Panels mit organischen Photodioden kann eine solche Aktiv-Matrix-Ansteuerung mit Dünnfilmtransistoren analog Verwendung finden. Die aktive Schicht der Photodiode, die über dem Dünnfilmtransistor und über den gezeigten strukturierten unteren Elektroden liegt, ist dann aus organischen Materialien aufgebaut. Der Querschnitt eines solchen Schichtsystems ist in Figur 3 gezeigt.

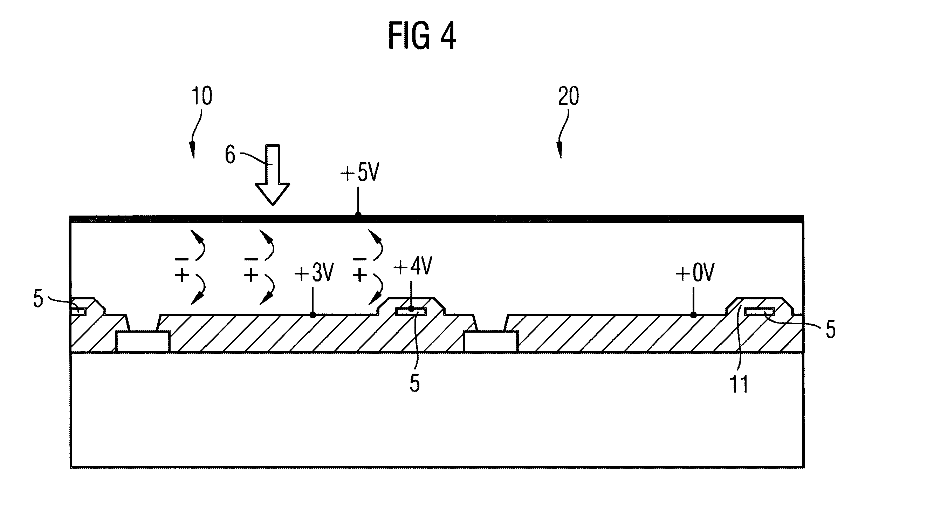

Die Top-Elektrode 2 ist bei einer solchen Aktiv-Matrix-Ansteuerung ebenfalls durchgehend. Typischerweise wird eine Biasspannung angelegt, so dass eine äußere treibende Kraft für die Trennung der Ladungsträger existiert. In der Figur 3 und 4 ist beispielhaft an der oberen Elektrode eine positive Spannung angelegt, während die elektrisch getrennten unteren Elektroden im noch unbeleuchteten Zustand auf 0V liegen (wie für Pixel 20 in Figuren 3 und 4). Die Richtung der verwendeten Bias-Spannung hängt dabei immer von der Polarität der Diode ab.

Das linke Pixel (Pixel 10, Figur 3) stellt nun ein beleuchtetes Pixel dar. Die durch das Licht generierten Ladungsträger werden dann zu den beiden Elektroden transportiert, und es ändert sich der Ladungszustand der Kapazität zwischen den beiden Pixelelektroden. Diese Änderung entspricht einem Entladen des ursprünglichen Bias-Zustandes, so dass auch die untere Elektrode allmählich auf ein positives Potential angehoben wird, wie im Bild dargestellt. Die Konsequenz hieraus ist, dass weitere generierte Ladungsträger auf benachbarte Bottom-Elektroden 1 abfließen können, wo der Potentialunterschied noch höher ist. Beim darauf folgenden Auslesezyklus wird daher ein anteiliges Signal auf den benachbarten, unbeleuchteten Pixeln gemessen. Dieses Problem bezieht sich grundsätzlich sowohl auf benachbarte Pixel (10,20) einer Zeile, benachbarte Pixel einer Spalte, diagonal benachbarte Pixel und möglicherweise sogar weiter entfernte Pixel.

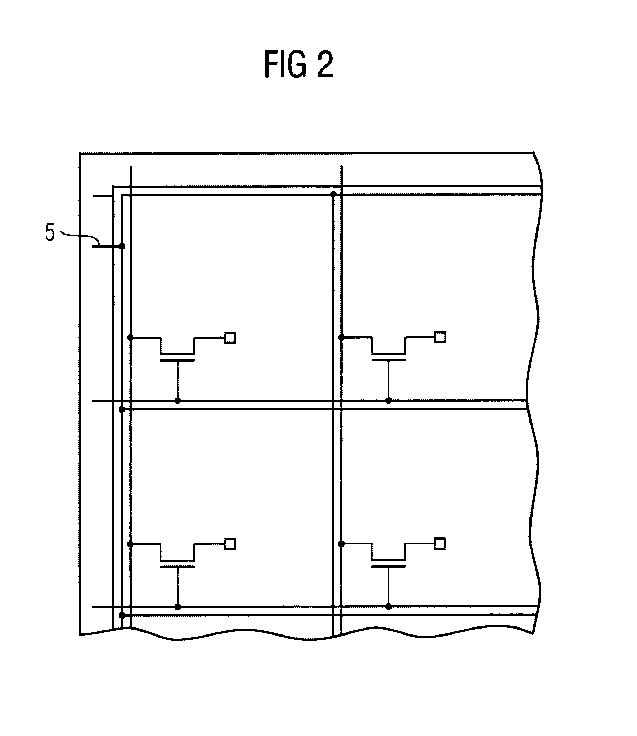

Die in dieser Erfindung vorgeschlagene Lösung des Problems besteht darin, einen zusätzlichen leitfähigen Kontakt einzufügen, der in einer Gitterstruktur zwischen allen Pixelzwischenräumen angeordnet ist. Dieses Gitter kann entweder - wie in Figur 2 skizziert - neben den Source- 13 und Gate-Leitungen 12 verlaufen oder auch (durch die Passivierungsschicht elektrisch getrennt) über diesen Leitungen liegen. Ein besonderer Vorteil der vorgeschlagenen Lösung ist, dass die gitterförmige Elektrode aus dem gleichen leitfähigen Material bestehen kann wie der untere Kontakt der Dioden, so dass auch die Strukturierung dieser Elektrode im gleichen Prozessschritt erfolgen kann wie die Strukturierung des unteren Kontaktes. Es ist lediglich nötig, über der Gitterelektrode noch eine zusätzliche, strukturierte Passivierungsschicht aufzubringen, um einen Ladungstransport vom organischen Material in diese Elektrode zu verhindern.

Wie in Figur 4 angedeutet, wird an die gitterförmige Separationselektrode ein positives Potential angelegt, was den lateralen Fluss von positiven Ladungsträgern über diesen Kontakt hinweg verhindert. Dieses Potential ist so ausgelegt sein, dass die negativen Ladungsträger trotzdem bevorzugt zur oberen Elektrode transportiert werden, aber es sollte höher sein als auf der unteren Elektrode eines maximal entladenen Pixels. Die genaue Wahl der verschiedenen Potentialniveaus hängt sowohl von der Lichtintensität ab, als auch von den Treiberbedingungen, von den seitlichen Dimensionen, von der Dicke des Halbleitermaterials und der Passivierungsschicht über der Gitterelektrode. Sämtliche Vorzeichen können auch umgekehrt sein wie in dem abgebildeten Beispiel dargestellt, abhängig von den Kontakten und somit der Polarität der Photodiode.

Der entscheidende Vorteil der angegebenen Erfindung ist, dass ein Übersprechen zwischen unterschiedlich beleuchteten Pixeln vermindert wird, ohne dass eine Strukturierung des organischen Halbleiters nötig wird. Es können daher weiterhin kostengünstige Prozessschritte wie Spin Coating, Rakeln oder Druckverfahren Verwendung finden. Die leitfähige Gitterelektrode kann in einem Schritt mit der unteren Elektrode der Dioden aufgebracht und strukturiert werden. Für die zusätzliche Passivierungsschicht über der Gitterstruktur kann der gleiche Prozess verwendet werden wie für die Passivierungsschicht unter der Elektrode, so dass sich insgesamt der Prozessaufwand nur wenig erhöht.

Flächig dargestellt ist die Bottom-Elektrode 1, die gemäß den Pixeln strukturiert ist, damit einzelne Pixel aktiviert werden können. Auf der entgegengesetzten Seite und hier nur am Rand noch sichtbar ist die Top-Elektrode 2, die flächig und unstrukturiert aufgebracht wird. Dazwischen liegt die organische aktive Schicht, die aus der Sicht ganz von der Top-Elektrodenschicht verdeckt wird. Beispielsweise wird die Top-Elektrode 2 mit einer Spannung von 5 Volt betrieben und die Bottom-Elektrode 1 im unbeleuchteten Zustand mit einer Spannung von 0 Volt. Zu erkennen ist noch der Kontaktpunkt 4 an dem der Durchkontakt von der Photodiode zu dem Transistor erfolgt.

Figur 2 zeigt das gleiche Bild aber ergänzt durch die Gitterelektrode 5 gemäß der Erfindung. Die Gitterelektrode wird bei dieser Ausführungsform über die ganze Fläche der Bottom-Elektrode 1 gelegt und umgrenzt in dem hier gezeigten Ausschnitt jeden einzelnen Pixel.
Figur 3 schließlich zeigt einen kleinen Ausschnitt, die Fläche von 1 ¾ Pixel umfassend und im Querschnitt, eine Photodiode nach dem Stand der Technik:

Von oben fällt Licht in der Richtung nach Pfeil 6 auf die Top-Elektrode 2, die beispielsweise aus einer aufgedampften semitransparenten Schicht aus Metallen wie Ba, Ca, Mg, Al, Ag sowie Kombinationen oder Legierungen dieser Metalle, Salzen wie LiF oder CsF oder Indium-Zinn-Oxid bestehen kann. sein kann. Durch diese semi-transparente Schicht tritt das Licht in die aktive organische Schicht ein, wo die Trennung der Ladungsträger erfolgt.
Dort setzen sich nun die innerhalb der Schicht generierten Ladungsträger in Bewegung und wandern entsprechend dem Vorzeichen der Ladung zur vollflächigen Top-Elektrode oder zur Bottom-Elektrode 1, die gemäß den einzelnen Pixel (Pixel 10 und Pixel 20) strukturiert ist.

Zu erkennen sind noch die Durchkontakte 4 zu den Transistoren. Zwischen der Bottom-Elektrode 1 und dem Substrat 9 befindet sich die isolierende Passivierungsschicht 11.

Der Aufbau befindet sich auf einem Substrat 9, auf das zur Ansteuerung der Pixel Dünnfilmtransistoren (TFTs) aus amorphem Silizium angeordnet sind

In der Figur 4 schließlich ist eine Ausführungsform gemäß der Erfindung zu sehen, bei der die Gitterelektrode 5 zum einen von der Passivierungsschicht 11 umgeben ist und zum anderen die Pixel 10 und 20 von einander trennt. Die Gitterelektrode 5 ist auch bei den zum Pixel 10 benachbarten Pixeln (beispielsweise am Pixel 20) zu sehen.

Der Vorteil liegt in der Einführung einer gitterförmig strukturierten Elektrode zwischen den strukturierten, unteren Elektroden der einzelnen Pixel, so dass ein abstoßendes Potential den Transport von Ladungsträgern zur benachbarten Bottom-Elektrode verhindert.

Der entscheidende Vorteil der angegebenen Erfindung ist, dass ein Übersprechen zwischen unterschiedlich beleuchteten Pixeln vermindert wird, ohne dass eine Strukturierung des organischen Halbleiters nötig wird. Es können daher weiterhin kostengünstige Prozessschritte wie Spin Coating, Rakeln oder Druckverfahren Verwendung finden. Die leitfähige Gitterelektrode kann in einem Schritt mit der unteren Elektrode der Dioden aufgebracht und strukturiert werden. Für die zusätzliche Passivierungsschicht über der Gitterstruktur kann der gleiche Prozess verwendet werden wie für die Passivierungsschicht unter der Elektrode, so dass sich insgesamt der Prozessaufwand nur wenig erhöht.

Die Erfindung ermöglicht erstmals eine Unterdrückung des Cross-Talk ohne kostspielige Strukturierung einer aktiven organischen leitenden oder halbleitenden Schicht.

Dies gelingt durch die Einführung einer gitterförmig strukturierten Elektrode zwischen den strukturierten, unteren Elektroden der einzelnen Pixel, so dass ein abstoßendes Potential den Transport von Ladungsträgern zur benachbarten Bottom-Elektrode verhindert.

## Patentansprüche

1. Elektronisches Bauelement mit zumindest einer aktiven organischen halbleitenden oder leitenden Schicht, die zwischen zwei Elektroden (1,2) eingebettet ist, **dadurch gekennzeichnet, dass** innerhalb des Schichtsystems und seitlich neben den pixelierten Elektroden eine Elektrode (5) in Form eines Gitters über den gesamten aktiven Bereich gelegt ist, wobei diese Gitterelektrode (5) mit einer Passivierungsschicht überzogen ist, einzelne oder mehrere Pixel umgrenzt und mit einer Spannung betrieben wird, die einem Ladungstransfer entlang der Schicht, also einem Übersprechen der einzelnen Pixel, entgegenwirkt.

2. Bauelement nach Anspruch 1, wobei das Bauelement eine Photodiode ist.

3. Bauelement nach einem der Ansprüche 1 oder 2, wobei die Gitterelektrode (5) aus Gold, Palladium, Chrom, Silber, Platin, oder Indium-Zinn-Oxid besteht.

4. Bauelement nach einem der vorstehenden Ansprüche, wobei der Querschnitt der Gitterelektrode (5) im Wesentlichen rund oder ellipsoid ist.

5. Bauelement nach einem der vorstehenden Ansprüche, wobei die Gitterelektrode (5) im Wesentlichen eckig ist.

6. Bauelement nach einem der vorstehenden Ansprüche, wobei die Periodizität des Gitters im Bereich von 50-500 µm liegt.

## Claims

1. Electronic component comprising at least one active, organic, semi-conductive or conductive layer which is embedded between two electrodes (1,2), **characterized in that** within the layer system and laterally next to the pixilated electrodes an electrode (5) in the form of a grid is placed over the entire active region, this grid electrode (5) being coated with a passivation layer, defining individual or a plurality of pixels and being operated at a voltage which counteracts a charge transfer along the layer, in other words crosstalk of the individual pixels.

2. Component according to claim 1, wherein the component is a photodiode.

3. Component according to either claim 1 or 2, wherein the grid electrode (5) is made from gold, palladium, chromium, silver, platinum or indium-tin oxide.

4. Component according to any one of the preceding claims, wherein the cross-section of the grid electrode (5) is substantially round or ellipsoidal.

5. Component according to any one of the preceding claims, wherein the grid electrode (5) is substantially angular.

6. Component according to any one of the preceding claims, wherein the periodicity of the grid is in the range of 50 to 500 µm.

## Revendications

1. Composant électronique comprenant au moins une couche organique active semi-conductrice ou conductrice qui est insérée entre deux électrodes (1, 2), **caractérisé en ce qu'**une électrode (5) sous forme de grille est posée sur l'ensemble de la zone active à l'intérieur du système de couche et latéralement à côté des électrodes pixélisées, cette électrode grille (5) étant recouverte d'une couche de passivation, délimitant des pixels individuels ou plusieurs pixels et fonctionnant à une tension qui s'oppose à un transfert de charge le long de la couche, et donc à une diaphotie des pixels individuels.

2. Composant selon la revendication 1, le composant étant une photodiode.

3. Composant selon l'une des revendications 1 ou 2, l'électrode grille (5) étant en or, en palladium, en chrome, en argent, en platine ou en oxyde d'étain et d'indium.

4. Composant selon l'une des revendications précédentes, la section transversale de l'électrode grille (5) étant essentiellement ronde ou ellipsoïde.

5. Composant selon l'une des revendications précédentes, l'électrode grille (5) étant essentiellement angulaire.

6. Composant selon l'une des revendications précédentes, la périodicité de la grille se situant dans la plage entre 50 µm et 500 µm.
